# EUROPÄISCHE PATENTSCHRIFT

(11) **EP 2 124 334 B1**
(45) Veröffentlichungstag und Bekanntmachung des Hinweises auf die Patenterteilung: **04.03.2015**
(21) Anmeldenummer: 09159149.5
(22) Anmeldetag: 30.04.2009
(51) Int. Cl.: H03H 17/02, H04R 25/00

(54) **Filterbanksystem für Hörgeräte**
Filter bank system for hearing aids
Système de banc de filtres pour appareils auditifs

(30) Priorität: 21.05.2008 DE 102008024490
(43) Veröffentlichungstag der Anmeldung: 25.11.2009
(73) Patentinhaber: Siemens Medical Instruments Pte. Ltd., Singapore 139959 (SG)
(72) Erfinder: Alfsmann, Daniel, 44787 Bochum (DE); Goeckler, Heinz, 71522 Backnang (DE)
(74) Vertreter: Maier, Daniel Oliver

(56) Entgegenhaltungen:
- EP-A2- 1 919 257
- DE-C1- 19 728 482
- DE-T2- 69 833 749
- US-A1- 2002 085 654
- CHAISAKUL P ET AL: "Number-of-band Selection for Acoustic Feedback Cancellation in Multi-band Compression Hearing Aids", TENCON 2006. 2006 IEEE REGION 10 CONFERENCE, 14. November 2006 (2006-11-14), Seiten 1-4, XP031333554, IEEE, PI ISBN: 978-1-4244-0548-0
- BRENNAN R ET AL: "A flexible filterbank structure for extensive signal manipulations in digital hearing aids", CIRCUITS AND SYSTEMS, 1998. ISCAS '98. PROCEEDINGS OF THE 1998 IEEE IN TERNATIONAL SYMPOSIUM ON, Bd. 6, 31. Mai 1998 (1998-05-31), - 3. Juni 1998 (1998-06-03), Seiten 569-572, XP010289846, Monterey, CA, USA ISBN: 0-7803-4455-3

## Beschreibung

Die vorliegende Erfindung betrifft ein Filterbanksystem für ein Hörgerät mit einer Analysefilterbank zum Zerlegen eines Eingangssignals in Teilbandsignale, einer Verarbeitungseinrichtung zum Verstärken mindestens eines der Teilbandsignale und einer Synthesefilterbank zum Zusammensetzen der verarbeiteten Teilbandsignale zu einem Ausgangssignal.

Hörgeräte sind tragbare Hörvorrichtungen, die zur Versorgung von Schwerhörenden dienen. Um den zahlreichen individuellen Bedürfnissen entgegenzukommen, werden unterschiedliche Bauformen von Hörgeräten wie Hinter-dem-Ohr-Hörgeräte (HdO), Hörgerät mit externem Hörer (RIC: receiver in the canal) und In-dem-Ohr-Hörgeräte (IdO), z.B. auch Concha-Hörgeräte oder Kanal-Hörgeräte (ITE, CIC), bereitgestellt. Die beispielhaft aufgeführten Hörgeräte werden am Außenohr oder im Gehörgang getragen. Darüber hinaus stehen auf dem Markt aber auch Knochenleitungshörhilfen, implantierbare oder vibrotaktile Hörhilfen zur Verfügung. Dabei erfolgt die Stimulation des geschädigten Gehörs entweder mechanisch oder elektrisch.

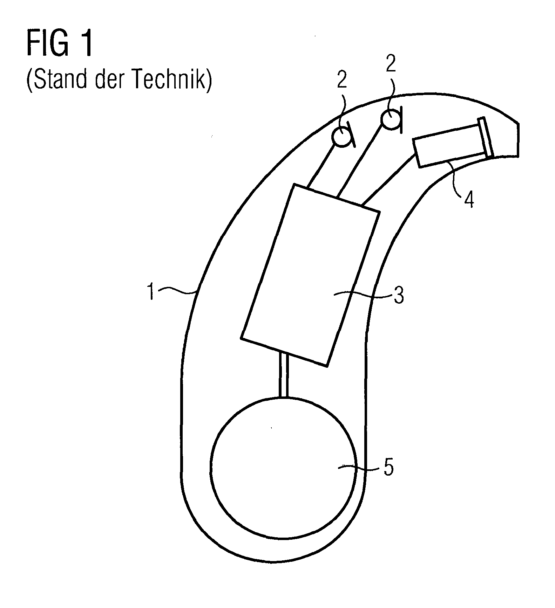

Hörgeräte besitzen prinzipiell als wesentliche Komponenten einen Eingangswandler, einen Verstärker und einen Ausgangswandler. Der Eingangswandler ist in der Regel ein Schallempfänger, z. B. ein Mikrofon, und/oder ein elektromagnetischer Empfänger, z. B. eine Induktionsspule. Der Ausgangswandler ist meist als elektroakustischer Wandler, z. B. Miniaturlautsprecher, oder als elektromechanischer Wandler, z. B. Knochenleitungshörer, realisiert. Der Verstärker ist üblicherweise in eine Signalverarbeitungseinheit integriert. Dieser prinzipielle Aufbau ist in FIG 1 am Beispiel eines Hinter-dem-Ohr-Hörgeräts dargestellt. In ein Hörgerätegehäuse 1 zum Tragen hinter dem Ohr sind ein oder mehrere Mikrofone 2 zur Aufnahme des Schalls aus der Umgebung eingebaut. Eine Signalverarbeitungseinheit 3, die ebenfalls in das Hörgerätegehäuse 1 integriert ist, verarbeitet die Mikrofonsignale und verstärkt sie. Das Ausgangssignal der Signalverarbeitungseinheit 3 wird an einen Lautsprecher bzw. Hörer 4 übertragen, der ein akustisches Signal ausgibt. Der Schall wird gegebenenfalls über einen Schallschlauch, der mit einer Otoplastik im Gehörgang fixiert ist, zum Trommelfell des Geräteträgers übertragen. Die Energieversorgung des Hörgeräts und insbesondere die der Signalverarbeitungseinheit 3 erfolgt durch eine ebenfalls ins Hörgerätegehäuse 1 integrierte Batterie 5.

Schallsignale, die von einem oder mehreren Mikrofonen eines Hörgeräts aufgenommen werden, werden üblicherweise zur weiteren Verarbeitung in Teilbandsignale zerlegt. Hierzu bedient man sich meist einer oder mehrerer frequenzselektiver digitaler Analysefilterbänke (AFB), wodurch K>1 Teilbandsignale erhalten werden. Nach der Zerlegung können teilbandspezifische Signalmanipulationen durchgeführt werden. Bei Hörgeräten sind dies insbesondere Verstärkungen in den einzelnen Teilbändern. Eine anschließende Resynthese der manipulierten Teilbandsignale kann mittels einer digitalen Synthesefilterbank (SFB) erfolgen.

An hochwertige Filterbänke in Hörgeräten werden gewisse Anforderungen gestellt. So wird beispielsweise in den untersten Bändern eine Kanalbandbreite von etwa 250 Hz benötigt. Ansonsten sollte sich der Bandabstand in etwa nach der Bark-Skala richten. Ferner ist eine Kanalzahl von mindestens 22 wünschenswert. Störanteile durch Aliasing sollten sicher unterhalb von 60 dB liegen. Aufgrund der intensiven Teilbandverarbeitung (insbesondere die hohe erforderliche Verstärkung zur Kompensation des Hörschadens) bei Hörgeräten sind herkömmliche Verfahren zur Auslöschung von Aliasing nicht wirksam. Die Filterbänke sind daher grundsätzlich "nicht kritisch" abzutasten. Des Weiteren sollte die Gruppenlaufzeit (jeweils für AFB und SFB) deutlich unter 5 ms liegen und die Gruppenlaufzeitverzerrungen einen gewissen Rahmen nicht überschreiten. Insbesondere für hohe Frequenzen ist dabei die Gruppenlaufzeit so gering wie möglich zu halten, was einen wesentlichen limitierenden Faktor für die Filterbank darstellt.

Das Dokument DE 197 28 482 Cl betrifft eine Schaltung zur Aufteilung eines Eingangssignals in mehrere Teilsignale sowie zur nachfolgenden Weiterverarbeitung und gegebenenfalls Wiedervereinigung zu einem Gesamtsignal.

Aus der Druckschrift DE 698 33 749 T2 ist eine Filterbankanordnung und ein Verfahren zur Filterung und Trennung eines Informationssignals in unterschiedlichen Frequenzbändern für Audiosignale in Hörhilfegeräten bekannt. In einer Analysefilterbank wird ein Eingangssignal in Teilbandsignale zerlegt. Die Teilbandsignale werden gegebenenfalls verstärkt und in einer Synthesefilterbank zu einem Ausgangssignal zusammengesetzt. In der Analysefilterbank werden die Signale überabgetastet.

Die Aufgabe der vorliegenden Erfindung besteht darin, die Teilbandverarbeitung in Hörgeräten weniger rechenaufwendig zu gestalten.

Erfindungsgemäß wird diese Aufgabe gelöst durch ein Filterbanksystem für ein Hörgerät mit einer Analysefilterbank zum Zerlegen eines Eingangssignals in Teilbandsignale, einer Verarbeitungseinrichtung zum Verstärken mindestens eines der Teilbandsignale und einer Synthesefilterbank zum Zusammensetzen der verarbeiteten Teilbandsignale zu einem Ausgangssignal, wobei die Teilbandsignale in der Analysefilterbank, der Verarbeitungseinrichtung und der Synthesefilterbank mit einem Überabtastfaktor U überabgetastet und gegenüber dem Eingangssignal mit einem Abwärtstastfaktor abwärtsgetastet sind, die Sperrdämpfungen der einzelnen Filter der Analysefilterbank mindestens so hoch sind wie ein vorgegebener erster Signal-Störabstand erhöht um einen ersten Dämpfungswert, der eine Funktion des Überabtastfaktors U und des Abwärtstastfaktors darstellt, und/oder der Synthesefilterbank mindestens so hoch sind wie ein vorgegebener zweiter Signal-Störabstand erhöht um einen zweiten Dämpfungswert, der eine Funktion des Überabtastfaktors U, des Abwärtstastfaktors und der Verstärkung der Verarbeitungseinrichtung darstellt, und der Betragsfrequenzgang der Synthesefilterbank näherungsweise mit dem Betragsfrequenzgang der Analysefilterbank abgestimmt ist, derart dass der komplexwertige Frequenzgang der Kaskade von Analysefilterbank und Synthesefilterbank unter Umgehung der Verarbeitungseinrichtung näherungsweise eine Allpass-Übertragungsfunktion ist.

In vorteilhafter Weise ist es durch die spezifischen Sperrdämpfungen der einzelnen Filter und der Betragsfrequenzanpassung möglich, die abwärts getasteten Teilbänder trotz der hörgerätetypischen Verstärkungen zu einem verhältnismäßig verzerrungsfreien Ausgangssignal zu rekonstruieren.

Vorzugsweise sind die AFB und die SFB jeweils als mehrstufige Filterbänke zur stufenweisen Erhöhung des Abwärtstastfaktors bzw. Aufwärtstastfaktors realisiert. Damit lassen sich in den einzelnen Teilbändern unterschiedliche Abwärtstastfaktoren nutzen.

Speziell können die AFB und/oder die SFB als Polyphasen-Filterbänke realisiert sein, wobei alle Einzelfrequenzgänge der Filterbänke jeweils von einem Prototypfilter durch Modulation abgeleitet sind. Damit lassen sich die Filterbänke ohne großen Aufwand entwerfen.

Gemäß einer Weiterbildung kann das Prototypfilter der AFB gegenüber dem Prototypfilter der SFB eine verschiedene Sperrdämpfung und/oder eine verschiedene Dämpfung und/oder eine verschiedene Dämpfung im Durchlassbereich besitzen. Damit muss nicht in beiden Filterbänken die gleiche hochqualitative Sperrdämpfung durchgeführt werden.

Weiterhin können die AFB und die SFB jeweils ungleichförmige Filterbänke darstellen. Damit lassen sich in den Teilbandsignalen unterschiedliche Abtastraten bzw. Überabtastfaktoren realisieren.

Wenigstens eine der Filterbänke oder eine Teilfilterbank einer der Filterbänke kann minimalphasig oder linearphasig sein. Im Fall der Minimalphasigkeit besitzt die jeweilige Filterbank eine kleine Gruppenlaufzeit und im Fall der Linearphasigkeit eine konstante Gruppenlaufzeit.

Ebenso kann das Prototypfilter, das für die Filterbänke verwendet wird, minimalphasig oder linearphasig sein. Auch dies führt zu einer kleinen bzw. konstanten Gruppenlaufzeit.

Des Weiteren kann die Gruppenlaufzeit der einzelnen Filter der Filterbänke im jeweiligen Durchlassbereich im Wesentlichen konstant sein. Außerdem kann die Gruppenlaufzeit der Filter der Filterbänke in einem wesentlichen Teil des jeweiligen Übergangsbereichs vom Durchlassbereich zum Sperrbereich konstant sein. Je größer der Bereich der konstanten Gruppenlaufzeit ist, desto weniger Verzerrungen sind zu erwarten.

Entsprechend einer besonders bevorzugten Ausführungsform werden jeweils U Polyphasen-Zweigfilter (U = Überabtastfaktor) des Prototypfilters mit demselben Signal gespeist. Damit lassen sich bei der Realisierung der Filterbänke zahlreiche Signalspeicher einsparen.

Die vorliegende Erfindung wird anhand der beigefügten Zeichnungen näher erläutert, in denen zeigen:
- FIG 1: den prinzipiellen Aufbau eines Hörgeräts gemäß dem Stand der Technik;
- FIG 2: ein Filterbanksystem gemäß der vorliegenden Erfindung;
- FIG 3: den Betragsfrequenzgang eines Bandfilters einer der Filterbänke;
- FIG 4: den Betragsfrequenzgang des Filterbanksystems und
- FIG 5: den Aufbau eines Filters mit reduzierter Speicheranzahl.

Die nachfolgend näher geschilderten Ausführungsbeispiele stellen bevorzugte Ausführungsformen der vorliegenden Erfindung dar.

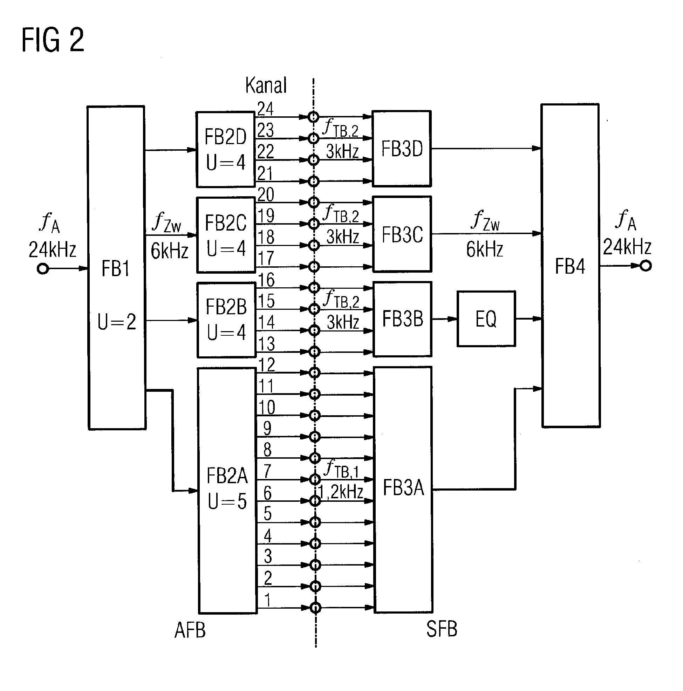

In FIG 2 ist ein Filterbanksystem, hier eine Filterbank-Kaskade bestehend aus einer mehrstufigen Analysefilterbank (AFB) und einer mehrstufigen Synthesefilterbank (SFB) dargestellt. Die beispielhafte Filterbank-Kaskade dient zur Signalverarbeitung in einer Hörvorrichtung und insbesondere in einem Hörgerät. Die eingangsseitige Filterbank (FB1) der AFB zerlegt das Eingangssignal in vier Kanäle. Die ausgangsseitigen Filterbänke FB2A, FB2B, FB2C und FB2D zerlegen die vier Kanäle weiter in letztlich 24 Kanäle. Der unterste Kanal der FB1 wird dabei durch die FB2A in zwölf Kanäle zerlegt, während die übrigen drei Kanäle der FB1 mit Hilfe der ausgangsseitigen Filterbänke FB2B, FB2C und FB2D jeweils in vier Kanäle zerlegt werden. Die Eingangsabtastrate der FB1 beträgt beispielsweise 24 kHz. Die Abtastrate zwischen den beiden Filterbankstufen f_{ZW} beträgt im gewählten Beispiel 6 kHz. Die Abtastraten in den Teilbandkanälen am Ausgang der AFB beträgt in den hohen Frequenzgruppen also nach den Filterbänken FB2B, FB2C und FB2D jeweils 3kHz. Die Abtastrate nach der Filterbank FB2A der unteren Frequenzgruppe beträgt 1,2 kHz. Es erfolgt hier also in vorteilhafter Weise eine Abwärtstastung mit dem Abwärtstastfaktor 8 bzw. 20.

Nach der AFB wird eine teilbandspezifische Signal-Manipulation insbesondere Verstärkung durchgeführt, die in FIG 2 jedoch nicht dargestellt ist. Der Übersicht halber schließt sich an die AFB in FIG 2 unmittelbar die SFB zur Resynthese des Signals an. Die SFB ist hinsichtlich der Filterbänke in den einzelnen Stufen symmetrisch zu der AFB aufgebaut. Demnach befinden sich in der untersten Stufe der SFB die Filterbänke FB3A, FB3B, FB3C und FB3D, die jeweils zwölf bzw. vier Teilbandsignale zu einem Signal zusammenfügen. Die vier resultierenden Signale mit einer Abtastrate von 6 kHz werden der höheren Synthesestufe FB4 zugeführt, die die Signale zu einem Ausgangssignal mit einer Abtastrate von 24 kHz zusammensetzt.

Die breiteren Filterbänke FB2A und FB3A in der unteren Frequenzgruppe führen hier auch zu einer erhöhten Gruppenlaufzeit τ_{g} gegenüber der nächst höheren Frequenzgruppe mit den schmäleren Filterbänken FB2B und FB3B. Daher wird der Filterbank FB3B ein Entzerrungsfilter (Equalizer EQ) nachgeschaltet. Dieses Entzerrungsfilter EQ erhöht die Gruppenlaufzeit der Filterbank FB3B an der oberen (höherfrequenten) Bandkante auf den Wert der Gruppenlaufzeit der Filterbank FB3A an deren unterer Bandkante.

Weiterhin ist FIG 2 zu entnehmen, dass in der ersten Filterbankstufe FB1 der Analysefilterbank ein Übertastfaktor U = 2 gewählt ist. Die Übertastfaktoren in der zweiten Stufe betragen 4 bzw. 5. Mit der so gewählten Filterbankstruktur lässt sich beispielsweise ein ca. 12 kHz breites Eingangssignal in 12 Kanäle der Bandbreite 240 Hz (Kanäle 1 bis 12) und in 12 Kanäle der Bandbreite 750 Hz (Kanäle 13 bis 24) zerlegen.

Die in FIG 2 dargestellte Filterbankstruktur der Analysefilterbank ist hinsichtlich Gruppenlaufzeit und Energieverbrauch optimiert. Diese AFB-Filterbankstruktur weist eine eingangsseitige und eine ausgangsseitige Filterbank auf der Basis eines vorgegebenen Filtertyps auf und lässt sich wie folgt ermitteln. Die eingangsseitige Filterbank besitzt als variierbaren ersten Parameter eine Kanalzahl und als variierbaren zweiten Parameter einen Überabtastfaktor. Für die Optimierung der mehrstufigen Filterbank wird nun eine Gruppenlaufzeit und eine Operationsrate jeweils für mehrere Wertepaare des ersten und zweiten Parameters ermittelt. Aus den Wertepaaren wird dasjenige ausgewählt, bei dem die zugehörige Gruppenlaufzeit und die zugehörige Operationsrate ein vorgegebenes Kriterium erfüllen, insbesondere möglichst gering sind. Die eingangsseitige Filterbank wird daraufhin mit der Kanalzahl und dem Überabtastfaktor entsprechend dem ausgewählten Wertepaar konfiguriert. Die SFB ist symmetrisch zu der AFB aufgebaut, mit Ausnahme des optional einsetzbaren Entzerrungsfilters EQ.

Die Teilbandsignale in den Kanälen 1 bis 24 der AFB, der SFB und der dazwischen befindlichen Verarbeitungseinrichtung sind also mit einem vorgegebenen Überabtastfaktor U abgetastet und gegenüber dem Eingangssignal mit einem Abwärtstastfaktor (hier 20 in den Kanälen 1 bis 12 und 8 in den Kanälen 13 bis 24) abwärts getastet.

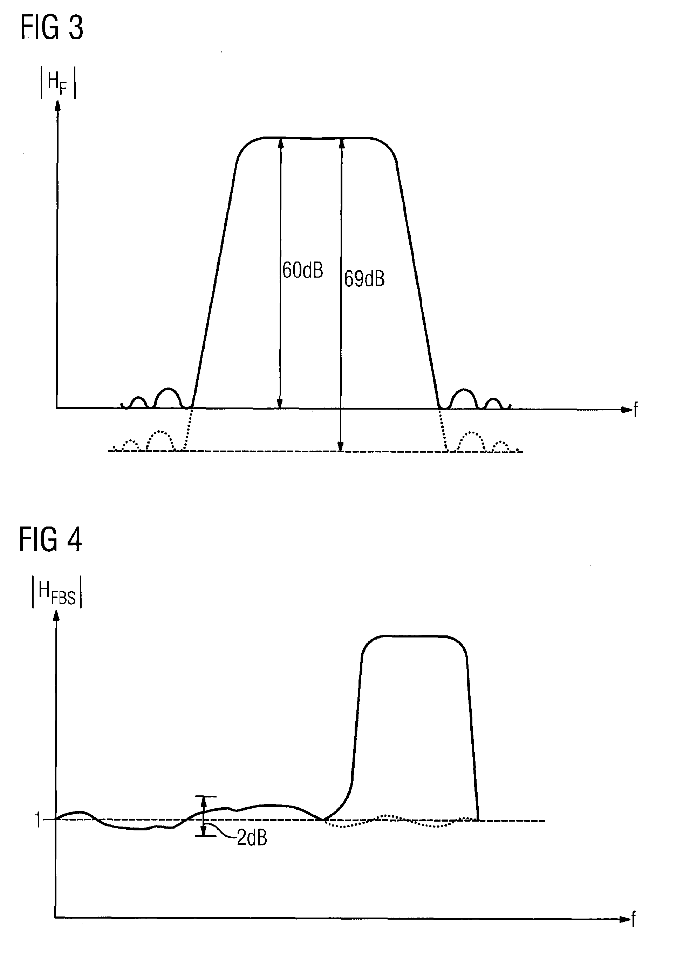

Die einzelnen Filter der AFB besitzen eine hinreichend hohe Sperrdämpfung, um nichtlineare Signalstörungen durch Aliasing zu vermeiden. Insbesondere ist die Sperrdämpfung mindestens so hoch wie ein gewünschter Signal-Störabstand. Hierzu ist in FIG 3 der Betragsfrequenzgang eines Filters aufgezeichnet. Wenn beispielsweise der Signal-Störabstand 60 dB betragen soll und keine weiteren Störungen durch Aliasing gegeben sind, kann die Sperrdämpfung des Filters 60 dB betragen. Sind allerdings weitere Störungen durch Aliasing-Komponenten zu erwarten, so muss die Sperrdämpfung entsprechend erhöht werden. Beispielsweise kann die Sperrdämpfung pro erwartete Aliasing-Komponente um 3 dB erhöht werden. Die Anzahl der zu erwartenden Aliasing-Komponenten lässt sich in üblicher Weise aus dem Überabtastfaktor und dem Abwärtstastfaktor ermitteln. In dem Beispiel von FIG 3 werden drei weitere Aliasingkomponenten erwartet, so dass die Sperrdämpfung um 3 · 3 dB = 9 dB auf insgesamt 69 dB erhöht wird.

Zusätzlich oder gegebenenfalls auch nur alternativ sind die Filter der SFB mit hinreichend hoher Sperrdämpfung auszustatten. Auch hier ist wieder der Ausgangspunkt der gewünschte Signal-Störabstand, der aber von dem Signal-Störabstand der Filter der AFB abweichen kann. Die Sperrdämpfung wird wiederum um einen geeigneten Dämpfungswert erhöht, der sich aus dem Überabtastfaktor und dem Abwärtstastfaktor ergibt. Bei der SFB ist jedoch zusätzlich zu beachten, dass in der Hörgerätesignalverarbeitungseinrichtung zumindest in einigen Teilbändern eine Signalverstärkung vorgesehen ist. Daher können auch unerwünschte Komponenten, insbesondere Imaging-Komponenten, die sich bei der Aufwärtstastung ergeben, entsprechend verstärkt werden. Diese gilt es ebenfalls ausreichend zu dämpfen. Folglich wird die Sperrdämpfung der Filter in der SFB auch in Abhängigkeit von der Verstärkung der Verarbeitungseinrichtung erhöht. Somit lassen sich auch nichtlineare Signalstörungen durch Imaging der SFB vermeiden. Eine Phasenanpassung (Phasematching) der SFB an die AFB zur Elimination von Aliasing findet jedoch ausdrücklich nicht statt. Dies ist bei einer Hörgeräteanwendung auch nicht sinnvoll.

Zusätzlich wird gemäß der vorliegenden Erfindung der Betragsfrequenzgang der SFB näherungsweise mit dem Betragsfrequenzgang der AFB abgestimmt. Dadurch erhält der komplexwertige Frequenzgang der Kaskade von AFB und SFB unter Umgehung der Verarbeitungseinrichtung näherungsweise eine Allpass-Übertragungsfunktion. Das Wort "näherungsweise" bezieht sich auf den üblichen Begriff der NPMR (Near Perfect Magnitude Reconstructions). Es soll hier also keine PMR (Perfect Magnitude Reconstructions) erfolgen, da dies aufgrund der Verstärkung in Teilbändern des Hörgeräts nicht sein darf. Die PMR würde nämlich zu einem transparenten System mit dem konstanten Übertragungsfaktor 1 also ohne Verstärkung führen. Es kann somit nicht die ansonsten für Filterbänke übliche perfekte Rekonstruktion mit entsprechender Aliasing-Kompensation, die sich rein mathematisch ableiten lässt, gewählt werden. Vielmehr ist hier zur Vermeidung von Störungen eine entsprechende Überabtastung sowie eine hinreichend hohe Sperrdämpfung zu wählen. Der Betragsfrequenzgang des Filterbanksystems ist darauf basierend entsprechend zu optimieren.

FIG 4 zeigt den Betragsfrequenzgang |*H_{FBS}*| eines Filterbanksystems, bei dem der Betragsfrequenzgang der SFB mit dem Betragsfrequenzgang der AFB abgestimmt ist, so dass sich näherungsweise ein Allpass ergibt, wenn die Hörgeräteverstärkung 1 beträgt. Konkret zeigt FIG 4 den Betragsfrequenzgang eines Hörgeräts zur Hochtonverstärkung. Nur in den höheren Kanälen findet hier eine Verstärkung statt. Wird diese Verstärkung unterbunden, ergibt sich ein transparentes System mit annähernd dem gleichen Verstärkungsfaktor 1 über den gesamten Frequenzbereich (vgl. gestrichelte Kurve im höheren Frequenzbereich von FIG 4). Durch die Filterbankstruktur ergeben sich jedoch gewisse Schwankungen des Betragsfrequenzgangs. Es liegt also keine mathematisch perfekte Rekonstruktion des Eingangssignals vor. Vielmehr rekonstruiert die Filterbankkaskade das Betragsspektrum des Eingangssignals nur näherungsweise perfekt. Die Schwankungsbreite liegt beispielsweise bei 2 dB.

Im Folgenden werden Varianten des erfindungsgemäßen Filterbanksystems vorgestellt, die zu weiteren Optimierungen führen können. So kann grundsätzlich die AFB und/oder die SFB als ein- oder mehrstufige Filterbank zur stufenweisen Verminderung bzw. Erhöhung der Abtastrate realisiert sein. Außerdem ist es günstig, wenn die AFB und/oder die SFB als (komplex oder reell modulierte) Polyphasen-Filterbänke realisiert sind, wobei alle Einzelfrequenzgänge der Filterbänke jeweils von einem Prototypfilter durch Modulation abgeleitet sind. Zur aufwandsgünstigen Realisierung der Filterbänke werden die rechengünstigen gleichförmigen, komplex modulierten (mit diskreter Fouriertransformation) Polyphasen-Filterbänke mit Überabtastung mit dem Faktor U eingesetzt (vgl. Heinz Göckler und Alexandra Groth "Multiratensysteme", Schlemmbachverlag, Willburgstätten, 2004). Bei diesen Polyphasen-Filterbänken wird nur ein Prototypfilter für alle Filterbank-Kanäle benötigt, und die Frequenzverschiebung wird mittels der effizienten FFT-Realisierung der DFT implementiert.

Des Weiteren kann die AFB und SFB als gleichförmige oder ungleichförmige Filterbänke mit gleicher bzw. unterschiedlicher Bandbreite der einzelnen Filterbankkanäle realisiert sein, wobei im Fall ungleichförmiger Filterbänke die Teilbandsignale unterschiedliche Abtastraten und/oder unterschiedliche Überabtastfaktoren aufweisen können. Außerdem kann der für die AFB verwendete Prototypfilter eine andere Sperrdämpfung und/oder einen anderen Frequenzgang im Durchlassbereich aufweisen als der Prototypfilter der SFB.

Wenigstens eine der (Teil-) Filterbänke des Filterbanksystems kann minimalphasig sein, d. h. die Nullstellen der Z-Transformierten der Filterbankübertragungsfunktion befinden sich innerhalb des Einheitskreises. Dies hat den Vorteil, dass die Gruppenlaufzeit dann verhältnismäßig klein ist. Auch das Prototypfilter selbst kann minimalphasig sein. Dabei ist es auch günstig, wenn die Gruppenlaufzeit des Prototypfilters bzw. der entsprechenden Filterbank im Filterdurchlassbereich und gegebenenfalls zusätzlich in Teilen des Filterübergangsbereichs zum Sperrbereich näherungsweise konstant ist. Dadurch können etwaige Verzerrungen reduziert werden.

Wenigstens eine der (Teil-) Filterbänke oder ein Prototypfilter dieser Filterbänke kann alternativ auch linearphasig sein. Dadurch ergibt sich eine konstante Gruppenlaufzeit, was unter Umständen von Vorteil sein kann.

Ferner können die Filterbänke bzw. die Prototypfilter nichtrekursiv (FIR-Filter) oder rekursiv (IIR-Filter) realisiert sein. Optional können die Filterbänke bzw. Prototypfilter auch teils vom FIR- und teils vom IIR-Typ sein. Im Falle von IIR-Filtern kann der Frequenzgang dem eines minimalphasigen Butterworth-Filter oder dem eines minimalphasigen inversen Tschebyscheff-Filter vom Typ 2 entsprechen.

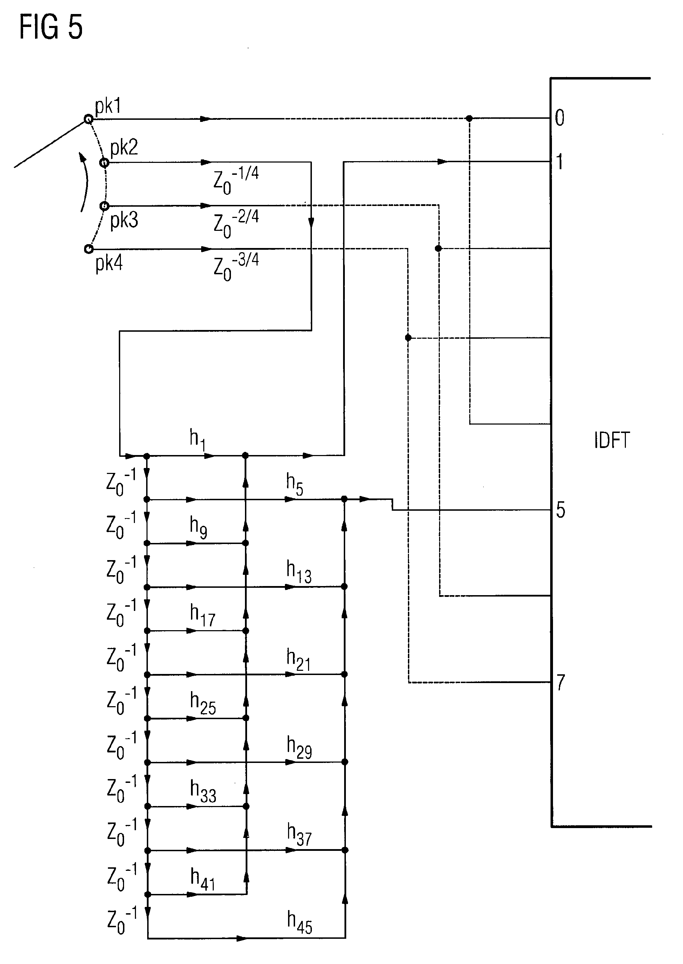

Besondere Vorteile ergibt sich bei der Nutzung der Überabtastung mit dem Faktor U zur Einsparung von Signalspeichern bei der Realisierung der Filterbänke mit FIR-Prototypfiltern. Es werden nämlich jeweils U Polyphasen-Zweigfilter h₁, h₅, h₉, ..., h₄₅ des FIR-Prototypfilters mit demselben Eingangsignal (wie etwa eine der PolyphasenKomponenten pk1, pk2, pk3 und pk4 des Eingangssignals) gespeist (vgl. FIG 5). Damit können jeweils U Zweigfilter auf denselben Satz von Signalspeichern (in FIG 5 jeweils mit z₀⁻¹ gekennzeichnet) zurückgreifen. Somit wird anstelle von U Signalspeicherketten für U Zweigfilter lediglich eine einzige Speicherkette benötigt.

Im konkreten Fall des Beispiels von FIG 5 beträgt der Überabtastfaktor zwei, denn aus den vier Polyphasenkomponenten pk1 bis pk4 werden acht Komponenten entsprechend den Eingängen 0 bis 7 des IDFT-Bausteins für die inverse, diskrete Fouriertransformation gewonnen. Speziell werden, wie in FIG 5 dargestellt ist, aus der Polyphasen-Komponente pk2 mit einer einzigen Signalspeicherkette (z₀⁻¹-Kette) die erste und fünfte Komponente für die IDFT gewonnen. Die gleiche Einsparung ist möglich bei den entsprechenden Filtern der SFB, da deren Struktur grundsätzlich durch Transponierung (vgl. Heinz Göckler und Andrea Groth, a.a.O.) auf AFB-Strukturen zurückführbar ist.

## Patentansprüche

1. Filterbanksystem für ein Hörgerät mit
- einer Analysefilterbank (AFB) mit einer Mehrzahl an einzelnen Filtern zum Zerlegen eines Eingangssignals in Teilbandsignale,
- einer Verarbeitungseinrichtung zum Verstärken mindestens eines der Teilbandsignale und
- einer Synthesefilterbank (SFB) mit einer Mehrzahl an einzelnen Filtern zum Zusammensetzen der verarbeiteten Teilbandsignale zu einem Ausgangssignal,
- die Teilbandsignale in der Analysefilterbank (AFB), der Verarbeitungseinrichtung und der Synthesefilterbank (SFB) mit einem Überabtastfaktor U überabgetastet und gegenüber dem Eingangssignal mit einem Abwärtstastfaktor abwärtsgetastet sind, **dadurch gekennzeichnet, dass**
- die Sperrdämpfungen der einzelnen Filter
* der Analysefilterbank (AFB) mindestens so hoch sind wie ein vorgegebener erster Signal-Störabstand erhöht um einen ersten Dämpfungswert, der eine Funktion des Überabtastfaktors U und des Abwärtstastfaktors darstellt, und/oder
* der Synthesefilterbank mindestens so hoch sind wie ein vorgegebener zweiter Signal-Störabstand erhöht um einen zweiten Dämpfungswert, der eine Funktion des Überabtastfaktors U, des Abwärtstastfaktors und der Verstärkung der Verarbeitungseinrichtung darstellt, und
- der Betragsfrequenzgang der Synthesefilterbank (SFB) näherungsweise mit dem Betragsfrequenzgang der Analysefilterbank (AFB) abgestimmt ist, derart dass
- der komplexwertige Frequenzgang der Kaskade von Analysefilterbank (AFB) und Synthesefilterbank (SFB) unter Umgehung der Verarbeitungseinrichtung näherungsweise eine Allpass-Übertragungsfunktion ist.

2. Filterbanksystem nach Anspruch 1, wobei die Analysefilterbank (AFB) und die Synthesefilterbank (SFB) jeweils als mehrstufige Filterbänke zur stufenweisen Erhöhung der Abwärtstastfaktors bzw. Aufwärtstastfaktor realisiert sind.

3. Filterbanksystem nach Anspruch 1 oder 2, wobei die Analysefilterbank (AFB) und/oder die Synthesefilterbank (SFB) als Polyphasen-Filterbänke realisiert sind, und wobei alle Einzelfrequenzgänge der Filterbänke jeweils von einem Prototypfilter durch Modulation abgeleitet sind.

4. Filterbanksystem nach Anspruch 3, wobei das Prototypfilter der Analysefilterbank (AFB) gegenüber dem Prototypfilter der Synthesefilterbank (SFB) eine verschiedene Sperrdämpfung und/oder eine verschiedene Dämpfung im Durchlassbereich besitzt.

5. Filterbanksystem nach einem der vorhergehenden Ansprüche, wobei die Analysefilterbank (AFB) und die Synthesefilterbank (SFB) jeweils ungleichförmige Filterbänke sind.

6. Filterbanksystem nach einem der vorhergehenden Ansprüche, wobei wenigstens eine der Filterbänke oder eine Teilfilterbank (FB1 bis FB4) einer der Filterbänke minimalphasig oder linearphasig ist.

7. Filterbanksystem nach Anspruch 3, wobei das Protoypfilter minimalphasig oder linearphasig ist.

8. Filterbanksystem nach Anspruch 6 oder 7, wobei die Gruppenlaufzeit der einzelnen Filter der Filterbänke im jeweiligen Durchlassbereich im Wesentlichen konstant ist.

9. Filterbanksystem nach einem der vorhergehenden Ansprüche, wobei die Gruppenlaufzeit der einzelnen Filter der Filterbänke in einem wesentlichen Teil des jeweiligen Übergangsbereichs vom Durchlassbereich zum Sperrbereich konstant ist.

10. Filterbanksystem nach einem der Ansprüche 3 bis 9, wobei jeweils U Polyphasen-Zweigfilter (h₁ bis h₄₅) des Prototypfilters mit demselben Signal gespeist werden.

## Claims

1. Filter bank system for a hearing aid, comprising
- an analysis filter bank (AFB) with a plurality of individual filters for decomposing an input signal into sub-band signals,
- a processing device for amplifying at least one of the sub-band signals, and
- a synthesis filter bank (SFB) with a plurality of individual filters for combining the processed sub-band signals into an output signal,
- the sub-band signals are oversampled in the analysis filter bank (AFB), the processing device and the synthesis filter bank (SFB) with an oversampling factor U and downsampled compared to the input signal with a downsampling factor, **characterised in that**
- the stopband attenuations of the individual filters
* of the analysis filter bank (AFB) are at least as high as a predefined first signal-to-noise ratio increased by a first attenuation value which is a function of the oversampling factor U and the downsampling factor, and/or
* of the synthesis filter bank are at least as high as a predefined second signal-to-noise ratio increased by a second attenuation value which is a function of the oversampling factor U, the downsampling factor and the gain of the processing device, and
- the magnitude frequency response of the synthesis filter bank (SFB) is approximately matched to the magnitude frequency response of the analysis filter bank (AFB) such that
- the complex-valued frequency response of the cascade analysis filter bank (AFB) and synthesis filter bank (SFB) bypassing the processing device is approximately an all-pass transfer function.

2. Filter bank system according to claim 1, wherein the analysis filter bank (AFB) and the synthesis filter bank (SFB) are in each case implemented as multistage filter banks for incrementally increasing the downsampling factor and upsampling factor respectively.

3. Filter bank system according to claim 1 or 2, wherein the analysis filter bank (AFB) and/or the synthesis filter bank (SFB) are implemented as polyphase filter banks, and wherein all the individual frequency inputs of the filter banks are derived in each case from one prototype filter by modulation.

4. Filter bank system according to claim 3, wherein the prototype filter of the analysis filter bank (AFB) has a different stopband attenuation and/or a different attenuation in the passband from that of the prototype filter of the synthesis filter bank (SFB).

5. Filter bank system according to one of the preceding claims, wherein the analysis filter bank (AFB) and the synthesis filter bank (SFB) are non-uniform filter banks.

6. Filter bank system according to one of the preceding claims, wherein at least one of the filter banks or a sub-filter bank (FB1 to FB4) of one of the filter banks is minimum phase or linear phase.

7. Filter bank system according to claim 3, wherein the prototype filter is minimum phase or linear phase.

8. Filter bank system according to claim 6 or 7, wherein the group delay of the individual filters of the filter banks is essentially constant in the respective passband.

9. Filter bank system according to one of the preceding claims, wherein the group delay of the individual filters of the filter banks is constant in a significant part of the respective transitional region from passband to stopband.

10. Filter bank system according to one of claims 3 to 9, wherein U polyphase branch filters (h₁ to h₄₅) of the prototype filter are each fed the same signal.

## Revendications

1. Système de banc de filtres pour une prothèse auditive, comprenant
- un banc ( AFB ) de filtres d'analyse ayant une pluralité de filtres individuels pour décomposer un signal d'entrée en des sous-signaux de bande,
- un dispositif de traitement pour amplifier au moins l'un des sous-signaux de bande et
- un banc ( SFP ) de filtres de synthèse ayant une pluralité de filtres individuels pour composer les sous-signaux de bande traités en un signal de sortie,
- les sous-signaux de bande dans le banc ( AFB ) de filtres d'analyse dans le dispositif de traitement et dans le banc ( SFB ) de filtres de synthèse étant suréchantillonnés par un facteur U de suréchantillonnage et étant sous-échantillonnés par un facteur de sous-échantillonnage par rapport au signal d'entrée,
**caractérisé en ce que**
- les atténuations de blocage des divers filtres
* du banc ( AFB ) de filtres d'analyse sont au moins si grandes qu'un premier écart signal-bruit donné à l'avance est augmenté d'une première valeur d'atténuation, qui représente une fonction du facteur U de suréchantillonnage et du facteur de suréchantillonnage, et/ou
* du banc de filtres de synthèse sont au moins si grandes qu'un deuxième écart signal-bruit donné à l'avance est augmenté d'une deuxième valeur d'atténuation, qui représente une fonction du facteur U de suréchantillonnage, du facteur de sous-échantillonnage et de l'amplification du dispositif de traitement, et
- la réponse harmonique en valeur absolue du banc ( SFB ) de filtres de synthèse est adaptée à peu près à la fréquence harmonique absolue du banc ( AFB ) de filtres d'analyse, de manière à ce que
- la réponse harmonique en valeur complexe de la cascade du banc ( AFB ) de filtres d'analyse et du banc ( SFB ) de filtres de synthèse soit, en contournant le dispositif de traitement, à peu près une fonction de transfert passe-tout.

2. Système de banc de filtres suivant la revendication 1, dans lequel le banc ( AFB ) de filtres d'analyse et le banc ( SFB ) de filtres de synthèse sont réalisés respectivement sous la forme de bancs de filtres à plusieurs étages pour l'augmentation par palier du facteur de sous-échantillonnage et du facteur de suréchantillonnage.

3. Système de banc de filtres suivant la revendication 1 ou 2, dans lequel le banc ( AFB ) de filtres d'analyse et/ou le banc ( SFB ) de filtres de synthèse sont réalisés sous la forme de bancs de filtres polyphasés et dans lequel tous les harmoniques individuelles de fréquence des bancs de filtres sont dérivées par modulation respectivement d'un filtre prototype.

4. Système de banc de filtres suivant la revendication 3, dans lequel le filtre prototype du banc ( AFB ) de filtres d'analyse a, par rapport aux filtres prototypes du banc ( SFB ) de filtres de synthèse, une atténuation de blocage différente et/ou une atténuation différente dans la bande passante.

5. Système de banc de filtres suivant l'une des revendications précédentes, dans lequel le banc ( AFB ) de filtres d'analyse et le banc ( SFB ) de filtres de synthèse sont des bancs de filtres respectivement non uniformes.

6. Système de banc de filtres suivant l'une des revendications précédentes, dans lequel au moins l'un des bancs de filtres ou un sous-banc de filtres ( FB1 à FB4 ) de l'un des bancs de filtres est à phase minimum ou à phase linéaire.

7. Système de banc de filtres suivant la revendication 3, dans lequel le filtre prototype est à phase minimum ou à phase linéaire.

8. Système de banc de filtres suivant la revendication 6 ou 7, dans lequel le temps de propagation de groupe des divers filtres des bancs de filtres, dans la bande passe respective, est sensiblement constant.

9. Système de banc de filtres suivant l'une des revendications précédentes, dans lequel le temps de propagation de groupe des divers filtres des bancs de filtres, dans une partie essentielle de la zone de transition de la bande passante à la bande de suppression, est constant.

10. Système de banc de filtres suivant l'une des revendications 3 à 9, dans lequel chaque filtre ( h₁ à h₄₅) à deux branches polyphasé en U du filtre prototype est alimenté en le même signal.
